# EUROPEAN PATENT SPECIFICATION

(11) **EP 3 106 538 B1**
(45) Date of publication and mention of the grant of the patent: **21.04.2021**
(21) Application number: 16171813.5
(22) Date of filing: 27.05.2016
(51) Int. Cl.: C23C 14/04, C23C 14/30, F01D 5/28, C23C 14/08

(54) **UNIFORM THICKNESS THERMAL BARRIER COATING FOR NON LINE OF SIGHT AND LINE OF SIGHT AREAS**
GLEICHMÄSSIG DICKE WÄRMEDÄMMSCHICHT FÜR NICHTVISIERLINIEN- UND VISIERLINIENBEREICHE
REVÊTEMENT DE PROTECTION THERMIQUE D'ÉPAISSEUR UNIFORME POUR DES ZONES DE NON LIGNE DE VISÉE ET LIGNE DE VISÉE

(30) Priority: 01.06.2015 US 201514726947
(43) Date of publication of application: 21.12.2016
(73) Proprietor: Raytheon Technologies Corporation, Farmington, CT 06032 (US)
(72) Inventor: NEAL, James, Ellington, CT 06029 (US); LITTON, David, West Hartford, CT 06107 (US); SCHLICHTING, Kevin, South Glastonbury, CT 06073 (US); JORZIK, Eric, Montgomery, NY 12549 (US); HAZEL, Brian, Avon, CT 06001 (US); MALONEY, Michael, Marlborough, CT 06447 (US)
(74) Representative: Dehns

(56) References cited:
- EP-A1- 2 511 396
- US-A1- 2005 255 242
- US-A1- 2010 247 809
- THERON M. RODGERS ET AL: "Thermal barrier coating deposition by rarefied gas jet assisted processes: Simulations of deposition on a stationary airfoil", JOURNAL OF VACUUM SCIENCE AND TECHNOLOGY: PART A., vol. 31, no. 6, 1 January 2013 (2013-01-01), page 061509, XP055313667, MELVILLE, NY., US ISSN: 0734-2101, DOI: 10.1116/1.4819242

## Description

### BACKGROUND

The present disclosure relates to electron beam physical vapor deposition, and more particularly, to deposition upon non line of sight areas.

Electron Beam Physical Vapor Deposition (EB-PVD) is a form of physical vapor deposition in which an ingot of material is bombarded with an electron beam given off by a charged tungsten filament under high vacuum. The electron beam causes atoms from the ingot to transform into the gaseous phase. These atoms then condense into solid form, coating a workpiece in the vacuum chamber, and within a line of sight, with a thin layer of the material.

Industry standard operating parameter EB-PVD is performed in middle vacuum (3x10-4 to 5x10-3 Torr) under long mean free molecular path conditions which results in virtually straight line molecular paths between the ingot source and the deposition area on the workpiece. Contemporary airfoil components such as turbine blades and vanes employ complex airfoil and platform/shroud geometries with numerous coating areas that have reduced Line of Sight or Non Line of Sight (NLOS) areas to the ingot vapor. US 2005/0255242 discloses a direct vapour deposition method aimed at increasing the uniformity of coating thickness. Rodgers et al., J. Vac. Sci. Technol. A, Vol. 31, No. 6, pages 061509-1-14 discusses simulations of deposition on a stationary airfoil. US 2010/0247809 discloses EB-PVD apparatus for deposition of multi-layer coatings.

### SUMMARY

The invention is defined by the appended claims relating to a method of Electron Beam Physical Vapor Deposition.

A coated component according to one disclosed non-limiting embodiment of the present disclosure can include at least one Non Line of Sight (NLOS) area and at least one Line of Sight (LOS) area, a coating on the workpiece defines a ratio greater than about 10% NLOS/LOS. A further embodiment of the present disclosure provides a coated component with a coating applied by Electron Beam Physical Vapor Deposition (EB-PVD) comprising at least one Non Line of Sight (NLOS) area and at least one Line of Sight (LOS) area, a coating on the workpiece defining a ratio greater than about 10% NLOS/LOS, optionally wherein said at least one Non Line of Sight (NLOS) area includes an area adjacent to an airfoil and said at least one Line of Sight (LOS) area includes a leading edge of the airfoil.

A further embodiment of the present disclosure may include, wherein the coating applied to the workpiece is at a ratio of between about 10% - 50% NLOS/LOS.

A further embodiment of any of the embodiments of the present disclosure may include, wherein the coating applied to the workpiece is at about 0.13-0.38 mm (5-15 mil) thick in the LOS area.

A further embodiment of any of the embodiments of the present disclosure may include, wherein the coating applied to the workpiece is at about 0.10-0.28 mm (4-11 mil) thick in the NLOS area.

A further embodiment of any of the embodiments of the present disclosure may include, wherein the coating applied to the workpiece is at about 0.13-0.38 mm (5-15 mil) thick at the LOS area and about 0.10-0.28 mm (4-11 mil) thick NLOS area.

A further embodiment of any of the embodiments of the present disclosure may include, wherein the coating applied to the workpiece is at a ratio of about 0.25 mm (10 mil) thick at the LOS area to about 0.10 mm (4 mil) thick at the NLOS area.

A further embodiment of any of the embodiments of the present disclosure may include, wherein the LOS area includes a leading edge of an airfoil.

A further embodiment of any of the embodiments of the present disclosure may include, wherein the NLOS area includes an area between two airfoils.

A coated component according to another disclosed non-limiting embodiment of the present disclosure can include at least one Non Line of Sight (NLOS) area including an area adjacent to an airfoil and at least one Line of Sight (LOS) area including a leading edge of the airfoil, a coating on the workpiece defines a ratio greater than about 10% NLOS/LOS, optionally wherein said coating is applied by Electron Beam Physical Vapor Deposition (EB-PVD).

A further embodiment of any of the embodiments of the present disclosure may include, wherein the coating applied to the workpiece is at a ratio of between about 10% - 50% NLOS/LOS.

A further embodiment of any of the embodiments of the present disclosure may include, wherein the coating applied to the workpiece is at about 0.13-0.38 mm (5-15 mil) thick in the LOS area.

A further embodiment of any of the embodiments of the present disclosure may include, wherein the coating applied to the workpiece is at about 0.10-0.28 mm (4-11 mil) thick in the NLOS area.

A further embodiment of any of the embodiments of the present disclosure may include, wherein the coating applied to the workpiece is at about 0.13-0.38 mm (5-15 mil) thick at the LOS area and about 0.10-0.28 mm (4-11 mil) thick NLOS area.

A further embodiment of any of the embodiments of the present disclosure may include, wherein the coating applied to the workpiece is at a ratio of about 0.25 mm (10 mil) thick at the LOS area to about 0.10 mm (4 mil) thick at the NLOS area.

A method of Electron Beam Physical Vapor Deposition (e.g. a method for producing a component as herein described) according to the present disclosure includes maintaining a deposition chamber at a pressure of 4-20 Pa; and positioning a workpiece with a part manipulator to position a workpiece within the deposition chamber and respect to an ingot to define at least one Non Line of Sight (NLOS) area and at least one Line of Sight (LOS) area, wherein the coating applied to the workpiece is at a ratio greater than about 10% NLOS/LOS. The method uses a 40-50kV electron beam. A coated workpiece produced by the methods described herein forms a further aspect of the disclosure.

A further embodiment of any of the embodiments of the present disclosure may include, wherein the coating applied to the workpiece is at about 0.13-0.38 mm (5-15 mil) thick at the LOS area.

A further embodiment of any of the embodiments of the present disclosure may include, wherein the coating applied to the workpiece is at about 0.10-0.28 mm (4-11 mil) thick at the NLOS area.

A further embodiment of any of the embodiments of the present disclosure may include, wherein the LOS area includes a leading edge of an airfoil.

A further embodiment of any of the embodiments of the present disclosure may include, wherein the NLOS area includes an area between two airfoils.

A further embodiment of any of the embodiments of the present disclosure may include, wherein the coating applied to the workpiece is at a ratio of between about 10% - 50% NLOS/LOS.

The foregoing features and elements may be combined in various combinations without exclusivity, unless expressly indicated otherwise. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

Various features will become apparent to those skilled in the art from the following detailed description of the disclosed non-limiting embodiment. The drawings that accompany the detailed description can be briefly described as follows:
Figure 1 is a partially schematic view of a deposition system; and
Figure 2 is a schematic view of an example workpiece for the deposition system illustrating a line of sight area and a non-line of sight area.

### DETAILED DESCRIPTION

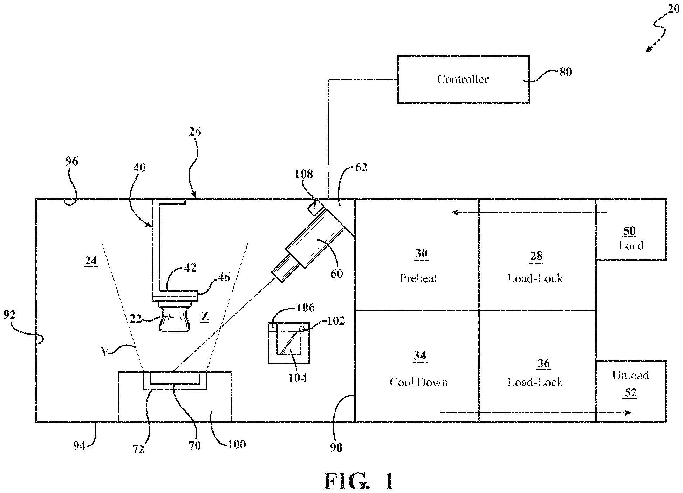

Figure 1 schematically illustrates an example system 20 for depositing coating on workpieces 22 in the interior 24 of a deposition chamber 26. The system 20 passes the workpiece 22 downstream along a workpiece flowpath sequentially through a first load lock chamber 28 forming an in-feed chamber, a preheat chamber 30, the deposition chamber 26, a cooldown chamber 34, and a second load lock chamber 36.

Each workpiece 22 may be conveyed through the system on a part holder 40 of which, depending upon implementation, may support a single workpiece or multiple workpieces. In the deposition chamber 26, the workpiece 22 may be manipulated by a sting mechanism 42. In one embodiment, a loading station 50 and an unloading station 52 are schematically illustrated. These may include robots (e.g., six-axis industrial robots) to transfer fixtured workpieces from and to conveyors, pallets, and the like. In another embodiment, the sting mechanism 42 advances the workpieces from the first load lock chamber 28 into the preheat chamber 30, and then into the deposition chamber 26. After deposition is complete, the sting mechanism 42 is withdrawn back through the preheat chamber 30 into the first load lock chamber 28, the workpieces are removed.

The exemplary deposition chamber 26 is configured for electron beam physical vapor deposition (EB-PVD). In this example, at least one electron beam (EB) gun 60 is positioned to direct its beam to one or more deposition material ingots 70, 72. In this example, there are two ingots 70, 72 of different materials. The ingots may be ceramics of different composition for forming distinct layers in a thermal barrier coating, erosion coating, abradable coating, or abrasive coating. For example, Zirconia-based ingot examples include, but are not limited to, a yttria-stabilized zirconia (YSZ) such as 7YSZ, a gadolinia-stabilized zirconia, or a YSZ of different yttria content or dopant. A part manipulator 46 may be used to position the workpiece 22 in distinct positions, or sets of positions, associated with deposition from the two distinct ingots so as to be approximately centrally positioned in a resulting vapor cloud V.

In one exemplary implementation, an electron beam gun 60 is positioned to raster both ingots and may be coupled to a control system 80 to sequentially heat the two sources for the two stages of deposition - or more stages if more than two layers are involved. The EB gun 60 may be positioned along a junction of the upper wall 96 and the sidewall 90 so as to diagonally point toward a thermal tray 100 containing the ingots 70, 72. In one example, a trajectory of primary particle residence time is about 0.1 seconds; a mean free path is about 1 cm.

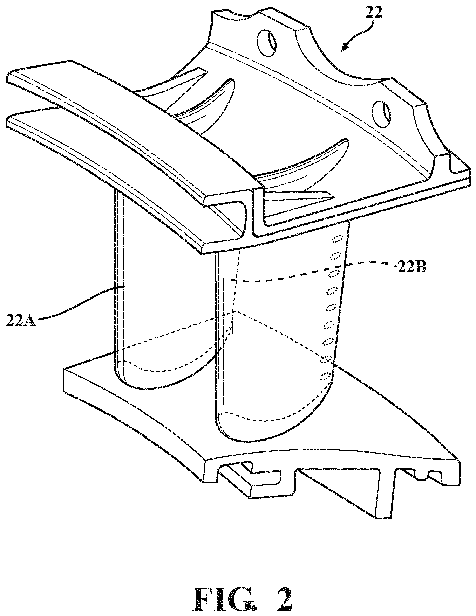

The vapor cloud V of particles from the ingots 70, 72 are directed onto the workpiece 22 generally in a Line of Sight (LOS) manner and a Non Line of Sight (NLOS) manner. That is, some areas 22A of the workpiece 22 such as a leading edge of a vane doublet (Figure 2) are directly exposed in a LOS manner to the particles of the vapor cloud while other areas 22B of the workpiece 22, such as the area between the airfoils of the vane doublet, have reduced Line Of Sight or NLOS to the particles and are thus termed NLOS areas with respect to the ingots 70, 72.

The deposition chamber 26 may further include gas purges 102 with O2 and/or Ar gases, that may be located adjacent one or more viewports 104. A stroboscope 106 may be located adjacent to the viewport 104 to prevent obscuring thereof. Further, a process gas manifold 108 may be directed into the deposition chamber 26, with gas flows ranging from 0.1 to 30 slpm. Process Gas manifolds of O₂ and/or Ar as well as gas purges with O₂, Ar, N₂, air, and/or mixtures thereof avoid ingress of vapor and nanoparticles. It should be appreciated that various other purges may alternatively or additionally be provided.

It is often beneficial to provide homogeneous microstructure coatings and constant coating thicknesses on all workpiece surfaces. LOS coating processes cannot provide such, and using longer coating cycle times to coat NLOS areas may cause other defects related to increased coating thickness in the LOS areas. In the invention the process gases support low vacuum operation (LVO) of the EB-PVD process in which mean free molecular paths are decreased thereby increasing collision rates with injected gasses to increase the amount of coating applied to the NLOS areas. The interior 24 of the deposition chamber 26 is maintained at between 4-20 Pa (10E-2 -10E-1 Torr). In another disclosed non-limiting embodiment, a pressure of 4-10 Pa may be utilized. The pressure may be selectively maintained by, for example, a process gas manifold of O₂ and a vacuum pump speed controlled by controller 80.

The electron beam is impinged onto the ingot within the deposition chamber 26 that maintains a chamber pressure up to about 100 times a conventional EBPVD pressure to compress the vapor cloud. The relatively higher chamber pressure requires a reatlively higher power electron beam that, in one example, is about 40kV - 50kV.

The compressed vapor cloud V facilitates a more uniform coating application to the LOS areas and the NLOS areas of the workpiece. Such variation reductions in the coating thickness between the LOS areas and the NLOS areas contribute to an increased service life. Notably, the variation reduction occurs at least in part due to an increase in the NLOS areas coating thickness with a concomitant reduction in LOS areas coating thickness. The molecules and particles are deflected via collisions due to the increased pressure into the NLOS areas which result in a significant change to the proportion of LOS areas to NLOS areas condensate thicknesses. That is, the increased gas collisions generated from the increased pressures bias the particles from the LOS areas to the NLOS areas at a non-constant magnitude.

In one example, a standard EB-PVD process at about 0.075 to 0.1 Pa pressures might produce an about 0.13-0.38 mm (5-15 mil) coating on the LOS areas such as the airfoil leading edge and a 0.05 mm (2 mil) coating on the NLOS areas. In contrast, the LVO EB-PVD process at about 4-20 Pa pressures produces an about 0.25 mm (10 mil) coating on the LOS areas such as the airfoil leading edge but provides an about 0.10 mm (4 mil) coating on the NLOS areas. That is, the LVO EB-PVD process results in a relative increase in the amount of coating to the NLOS areas. In one example, the LVO EB-PVD process increases a conventional 0.51 mm (20 mils) LOS / 0.05 mm (2 mils) NLOS, to 0.25 mm (10 mils) LOS / 0.10 mm (4 mils) NLOS ratio, or an about 10% NLOS/LOS to a 40% NLOS/LOS. In other words, for every 1 unit of thickness in the LOS area, the LVO EB-PVD produces a 0.4 increase on the NLOS areas.

The use of the terms "a," "an," "the," and similar references in the context of description (especially in the context of the following claims) are to be construed to cover both the singular and the plural, unless otherwise indicated herein or specifically contradicted by context. The modifier "about" used in connection with a quantity is inclusive of the stated value and has the meaning dictated by the context (e.g., it includes the degree of error associated with measurement of the particular quantity). All ranges disclosed herein are inclusive of the endpoints, and the endpoints are independently combinable with each other. Although the different non-limiting embodiments have specific illustrated components, the embodiments of this invention are not limited to those particular combinations. It is possible to use some of the components or features from any of the non-limiting embodiments in combination with features or components from any of the other non-limiting embodiments.

It should be appreciated that like reference numerals identify corresponding or similar elements throughout the several drawings. It should also be appreciated that although a particular component arrangement is disclosed in the illustrated embodiment, other arrangements will benefit herefrom.

Although particular step sequences are shown, described, and claimed, it should be understood that steps may be performed in any order, separated or combined unless otherwise indicated and will still benefit from the present disclosure.

## Claims

1. A method of Electron Beam Physical Vapor Deposition, comprising:
positioning a workpiece (22) with a part manipulator to position said workpiece (22) within a deposition chamber (26) and with respect to a deposition material ingot, defining at least one Non Line of Sight (NLOS) area and at least one Line of Sight (LOS) area, wherein the coating applied to the workpiece is at a thickness ratio greater than 10% NLOS/LOS;
**characterized in that** said deposition chamber is maintained at a pressure of 4-20 Pa; and said method uses a 40-50kV electron beam.

2. The method as recited in claim 1, wherein the coating applied to the workpiece is 0.13-0.38 mm (5-15 mil) thick at the LOS area.

3. The method as recited in claim 1 or claim 2, wherein the coating applied to the workpiece is 0.10-0.28 mm (4-11 mil) thick at the NLOS area.

4. The method as recited in any one of claims 1 to 3, wherein the LOS area includes a leading edge of an airfoil.

5. The method as recited in any one of claims 1 to 4, wherein the NLOS area includes an area between two airfoils.

6. The method as recited in any one of claims 1 to 5, wherein the coating applied to the workpiece is at a thickness ratio of between 10% - 50% NLOS/LOS.

## Patentansprüche

1. Verfahren zur physikalischen Gasphasenabscheidung mittels Elektronenstrahl, umfassend:
Positionieren eines Werkstücks (22) mithilfe eines Teilemanipulators zum Positionieren des Werkstücks (22) in einer Abscheidungskammer (26) und in Bezug auf einen Abscheidungsmaterialblock derart, dass mindestens ein Nichtvisierlinienbereich (Non Line of Sight area - NLOS-Bereich) und mindestens ein Visierlinienbereich (Line of Sight area - LOS-Bereich) definiert wird, wobei die auf das Werkstück aufgetragene Beschichtung ein Dickeverhältnis von mehr als 10 % NLOS/LOS aufweist;
**dadurch gekennzeichnet, dass** die Abscheidungskammer bei einem Druck von 4-20 Pa gehalten wird und das Verfahren einen Elektronenstrahl mit 40-50 kV verwendet.

2. Verfahren nach Anspruch 1, wobei die auf das Werkstück aufgetragene Beschichtung in dem LOS-Bereich 0,13-0,38 mm (5-15 Millizoll) dick ist.

3. Verfahren nach Anspruch 1 oder Anspruch 2, wobei die auf das Werkstück aufgetragene Beschichtung in dem NLOS-Bereich 0,10-0,28 mm (4-11 Millizoll) dick ist.

4. Verfahren nach einem der Ansprüche 1 bis 3, wobei der LOS-Bereich eine Vorderkante eines Schaufelprofils beinhaltet.

5. Verfahren nach einem der Ansprüche 1 bis 4, wobei der NLOS-Bereich einen Bereich zwischen zwei Schaufelprofilen beinhaltet.

6. Verfahren nach einem der Ansprüche 1 bis 5, wobei die auf das Werkstück aufgetragene Beschichtung ein Dickeverhältnis von 10 %-50 % NLOS/LOS aufweist.

## Revendications

1. Procédé de dépôt physique en phase vapeur par faisceau d'électrons, comprenant :
le positionnement d'une pièce (22) avec un manipulateur de pièce pour positionner ladite pièce (22) à l'intérieur d'une chambre de dépôt (26) et par rapport à un lingot de matériau de dépôt, définissant au moins une zone de non ligne de visée (NLOS) et au moins une zone de ligne de visée (LOS), dans lequel le revêtement appliqué sur la pièce présente un rapport d'épaisseur NLOS/LOS supérieur à 10 % ;
**caractérisé en ce que** ladite chambre de dépôt est maintenue à une pression de 4 à 20 Pa ; et ledit procédé utilise un faisceau d'électrons de 40 à 50 kV.

2. Procédé selon la revendication 1, dans lequel le revêtement appliqué sur la pièce a une épaisseur de 0,13 à 0,38 mm (de 5 à 15 millièmes de pouce) au niveau de la zone LOS.

3. Procédé selon la revendication 1 ou la revendication 2, dans lequel le revêtement appliqué sur la pièce a une épaisseur de 0,10 à 0,28 mm (de 4 à 11 millièmes de pouce) au niveau de la zone NLOS.

4. Procédé selon l'une quelconque des revendications 1 à 3, dans lequel la zone LOS comporte un bord d'attaque d'un profil aérodynamique.

5. Procédé selon l'une quelconque des revendications 1 à 4, dans lequel la zone NLOS comporte une zone entre deux profils aérodynamiques.

6. Procédé selon l'une quelconque des revendications 1 à 5, dans lequel le revêtement appliqué sur la pièce présente un rapport d'épaisseur NLOS/LOS de 10 % à 50 %.
